# EUROPEAN PATENT SPECIFICATION

(11) **EP 3 901 532 B1**
(45) Date of publication and mention of the grant of the patent: **20.03.2024**
(21) Application number: 18943831.0
(22) Date of filing: 19.12.2018
(51) Int. Cl.: F24F 11/63, F24F 11/62, G05B 15/02, G06F 8/00, G06F 17/00, F24F 11/00, F24F 110/10, F24F 11/32, F24F 11/38, F24F 11/46, F25D 13/00, F25D 17/06, F25D 29/00

(54) **INFORMATION PROCESSING APPARATUS AND INFORMATION PROCESSING METHOD**
INFORMATIONSVERARBEITUNGSVORRICHTUNG UND INFORMATIONSVERARBEITUNGSVERFAHREN
DISPOSITIF DE TRAITEMENT D'INFORMATIONS ET PROCÉDÉ DE TRAITEMENT D'INFORMATIONS

(43) Date of publication of application: 27.10.2021
(73) Proprietor: Mitsubishi Electric Corporation, Tokyo 100-8310 (JP)
(72) Inventor: HAMADA, Mamoru, Tokyo 100-8310 (JP); WADA, Makoto, Tokyo 100-8310 (JP); NAKAMURA, Shinji, Tokyo 100-8310 (JP); MOTODANI, Mio, Tokyo 100-8310 (JP); TANAKA, Ryuta, Tokyo 100-8310 (JP)
(74) Representative: Studio Torta S.p.A.
(86) International application number: PCT/JP2018/046788
(87) International publication number: WO 2020/129181

(56) References cited:
- EP-A2- 2 735 986
- WO-A1-2018/131804
- JP-A- 2003 148 785
- JP-A- 2012 063 055
- JP-A- 2015 512 082
- JP-A- 2018 109 494
- US-A1- 2009 326 879
- US-A1- 2012 072 181
- US-A1- 2014 039 845
- US-A1- 2015 134 123

## Description

### Technical Field

The present invention discloses an information processing apparatus and a corresponding method for an airflow analysis using an analysis model.

### Background Art

Changing a temperature adjusting apparatus installed in an indoor space to another temperature adjusting apparatus is considered. In the following, changing a freezing apparatus installed in a freezing warehouse to another freezing apparatus is considered. Before such change of the freezing apparatuses is performed, an air flow analysis in the freezing warehouse is performed using an analysis model. Then, it is examined whether or not the freezing apparatus is changed to another freezing apparatus, by examining a result of the airflow analysis.

Patent Literature 1 discloses a method of the airflow analysis using the analysis model. In Patent Literature 1, the analysis model is generated which is obtained by modeling a size and shape of the indoor space where an air conditioner is installed, presence or absence of a window, a size of the window, a position of an entrance, the number of entrances, an orientation of the entrance, a placement position of the air conditioner in the indoor space, a type of the air conditioner, the number of the air conditioners, a usage purpose of the indoor space, and the like. Further, in Patent Literature 1, the airflow analysis of the indoor space is performed by using the generated analysis model.

### Citation List

### Patent Literature

Patent Literature 1: JP2003-148785A
Patent Literature 2: US 2015/134123

### Summary of Invention

### Technical Problem

However, it is difficult to accurately model an actual phenomenon in the indoor space from data listed in Patent Literature 1.

Therefore, a technique of Patent Literature 1 has a problem that a temperature distribution obtained by the airflow analysis is not necessarily accurate.

The present invention mainly aims to solve such a problem described above. More specifically, the present invention mainly aims to obtain an accurate temperature distribution in an indoor space by an airflow analysis.

### Solution to Problem

In order to solve the posed technical problem, an information processing apparatus and a corresponding information processing method according to the present invention are provided in the appended independent apparatus claim 1 and method claim 9. Further preferred embodiment of the invention are provided in the dependent claims.

### Advantageous Effects of Invention

In the present invention, a temperature distribution obtained by an airflow analysis using an analysis model and a temperature actually measured at a measurement point are collated with each other, and the analysis model is corrected based on a collation result. Therefore, according to the present invention, it is possible to obtain an accurate temperature distribution in an indoor space by performing the airflow analysis using the corrected analysis model.

### Brief Description of Drawings

Fig. 1 is a diagram illustrating a system configuration example according to a first embodiment of the invention;
Fig. 2 is a diagram illustrating an input/output of a replacement proposing apparatus according to the first embodiment of the invention;
Fig. 3 is a diagram illustrating a hardware configuration example of the replacement proposing apparatus according to the first embodiment of the invention;
Fig. 4 is a diagram illustrating a functional configuration example of the replacement proposing apparatus according to the first embodiment of the invention;
Fig. 5 is a flowchart illustrating an operation example of the replacement proposing apparatus according to the first embodiment of the invention;
Fig. 6 is a diagram illustrating examples of output data according to the first embodiment of the invention; and
Fig. 7 is a diagram illustrating a practice example using the replacement proposing apparatus according to the first embodiment of the invention.

### Description of Embodiments

Hereinafter, embodiments of the present invention will be described with reference to the drawings. In the following description of the embodiments and the drawings, the same reference numerals indicate the same or corresponding parts.

### First Embodiment.

### *** Description of Configuration ***

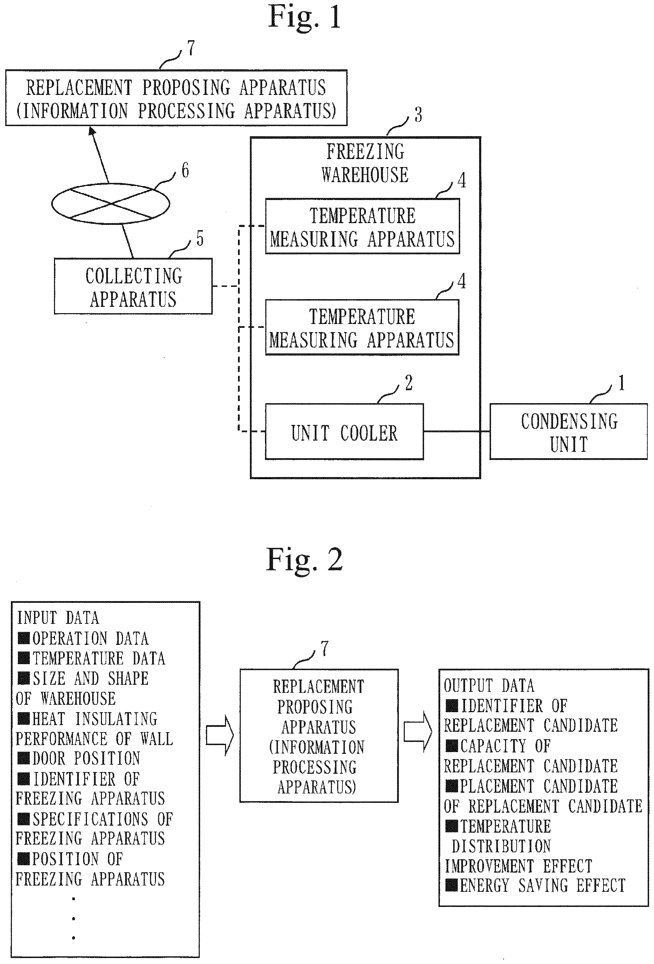

Fig. 1 illustrates a system configuration example according to the present embodiment.

Fig. 1 illustrates a state where a freezing apparatus configured by a condensing unit 1 and a unit cooler 2 is installed in a freezing warehouse 3.

The freezing warehouse 3 is an example of an indoor space. Further, the condensing unit 1 and the unit cooler 2 are examples of a temperature adjusting device.

One or more temperature measuring apparatuses 4 are placed in the freezing warehouse 3. A placement position of the temperature measuring apparatus 4 is referred to as a measurement point. The temperature measuring apparatus 4 measures a temperature at the measurement point.

A collecting apparatus 5 collects data (hereinafter, referred to as temperature data) of the temperature at the measurement point which is measured by the temperature measuring apparatus 4, and operation data of the freezing apparatus.

The collecting apparatus 5 transmits collected temperature data and operation data to a replacement proposing apparatus 7 via the Internet 6.

Here, the operation data is an ON/OFF signal of the condensing unit 1, blowout temperature data of the unit cooler 2, and the like.

The replacement proposing apparatus 7 is placed, for example, on a cloud network.

The replacement proposing apparatus 7 generates an analysis model for an airflow analysis. Further, the replacement proposing apparatus 7 performs the airflow analysis of the freezing warehouse 3 by using the generated analysis model. Further, the replacement proposing apparatus 7 collates the temperature measured by the temperature measuring apparatus 4 with a temperature distribution obtained by the air flow analysis, and corrects the analysis model based on a collation result. Further, the replacement proposing apparatus 7 performs the airflow analysis of the freezing warehouse 3 by using the analysis model which is after the correction, and extracts a freezing apparatus (an example of a replacement candidate device) which is a replacement candidate for the current freezing apparatus based on a result of the airflow analysis.

The replacement proposing apparatus 7 is an example of an information processing apparatus. Further, operation performed by the replacement proposing apparatus 7 is an example of an information processing method.

As illustrated in Fig. 2, the replacement proposing apparatus 7 acquires as input data, data (the operation data of the freezing apparatus and the temperature data of the measurement point) transmitted from the collecting apparatus 5.

Further, the replacement proposing apparatus 7 acquires as the input data, for example, data of: a size and shape of the freezing warehouse 3; heat insulating performance of walls of the freezing warehouse 3; a position of a door in the freezing warehouse 3; and an identifier, specifications, and a position of the freezing apparatus. The replacement proposing apparatus 7 may acquire at least a part of these pieces of data by input from an administrator of the replacement proposing apparatus 7. Further, at least the part of these pieces of data may be acquired as CAD (Computer-Aided Design) data.

Further, as illustrated in Fig. 2, the replacement proposing apparatus 7 outputs as output data: an identifier, a capacity, and a placement candidate of the freezing apparatus (the condensing unit and the unit cooler) which is a replacement candidate for realizing energy saving; a temperature distribution and an energy saving effect in the freezing warehouse 3 after changing to the freezing apparatus being the replacement candidate.

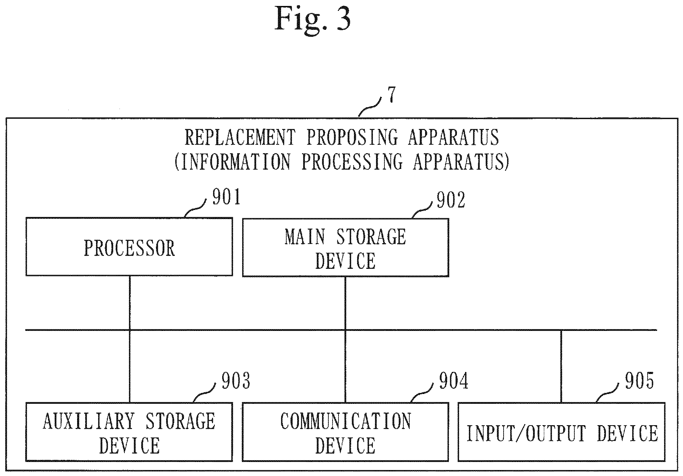

Fig. 3 illustrates a hardware configuration example of the replacement proposing apparatus 7 according to the present embodiment.

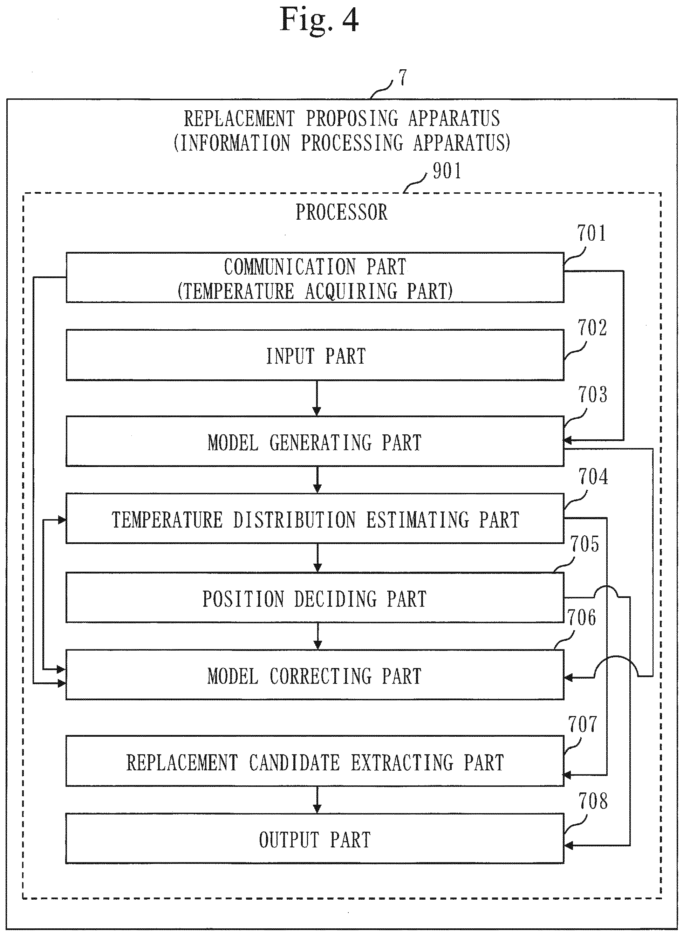

Fig. 4 illustrates a functional configuration example of the replacement proposing apparatus 7 according to the present embodiment.

The replacement proposing apparatus 7 according to the present embodiment is a computer.

As illustrated in Fig. 3, the replacement proposing apparatus 7 includes as pieces of hardware, a processor 901, a main storage device 902, an auxiliary storage device 903, a communication device 904, and an input/output device 905.

Further, as illustrated in Fig. 4, the replacement proposing apparatus 7 includes as functional configurations, a communication part 701, an input part 702, a model generating part 703, a temperature distribution estimating part 704, a position deciding part 705, a model correcting part 706, a replacement candidate extracting part 707, and an output part 708.

The auxiliary storage device 903 stores programs that realize functions of the communication part 701, the input part 702, the model generating part 703, the temperature distribution estimating part 704, the position deciding part 705, the model correcting part 706, the replacement candidate extracting part 707, and the output part 708.

These programs are loaded from the auxiliary storage device 903 into the main storage device 902. Then, the processor 901 executes these programs to perform operation of the communication part 701, the input part 702, the model generating part 703, the temperature distribution estimating part 704, the position deciding part 705, the model correcting part 706, the replacement candidate extracting part 707, and the output part 708 which will be described later.

Fig. 4 schematically illustrates a state where the processor 901 executes the programs that realize the functions of the communication part 701, the input part 702, the model generating part 703, the temperature distribution estimating part 704, the position deciding part 705, the model correcting part 706, the replacement candidate extracting part 707, and the output part 708.

In Fig. 4, the communication part 701 receives at least a part of input data illustrated in Fig. 2 from the collecting apparatus 5. For example, the communication part 701 receives from the collecting apparatus 5, the operation data of the freezing apparatus and the temperature data of the measurement point among the input data. The communication part 701 is an example of a temperature acquiring part.

The input part 702 can acquire at least the part of the input data illustrated in Fig. 2 by the input from the administrator of the replacement proposing apparatus 7. For example, the input part 702 acquires by the input from the administrator of the replacement proposing apparatus 7, data of: the size and shape of the freezing warehouse 3; the heat insulating performance of the walls of the freezing warehouse 3; the position of the door in the freezing warehouse 3; and the identifier, the specifications, and the position of the freezing apparatus; among the input data.

The model generating part 703 generates the analysis model for the airflow analysis of the freezing warehouse 3. More specifically, the model generating part 703 generates the analysis model that reflects the data of: the operation data of the freezing apparatus; the size and shape of the freezing warehouse 3; the heat insulating performance of the walls of the freezing warehouse 3; the position of the door in the freezing warehouse 3; and the identifier, the specifications, and the position of the freezing apparatus.

A method for generating the analysis model is not particularly specified. The model generating part 703 may generate the analysis model according to an existing method.

The temperature distribution estimating part 704 performs the airflow analysis of the freezing warehouse 3 by using the analysis model generated by the model generating part 703, and estimates the temperature distribution in the freezing warehouse 3.

Further, the temperature distribution estimating part 704 performs the airflow analysis of the freezing warehouse 3 by using the analysis model which is after being corrected by the model correcting part 706 which will be described later, and estimates the temperature distribution in the freezing warehouse 3.

Note that, a method for the airflow analysis is not particularly specified. The temperature distribution estimating part 704 may perform the airflow analysis according to an existing method.

The position deciding part 705 analyzes the temperature distribution estimated by the temperature distribution estimating part 704 and decides a position of the measurement point.

More specifically, the position deciding part 705 decides as the position of the measurement point, a characteristic point in the temperature distribution estimated by the temperature distribution estimating part 704. The characteristic point is, for example, a point where a highest temperature is estimated in the temperature distribution, a point where a lowest temperature is estimated in the temperature distribution, or the like. Besides, the administrator of the replacement proposing apparatus 7 can arbitrarily decide a condition for the characteristic point.

The model correcting part 706 collates the temperature distribution estimated by the temperature distribution estimating part 704 with the temperature data (the temperature at the measurement point) acquired by the communication part 701, and corrects the analysis model based on the collation result.

For example, when there is a difference between the temperature at the measurement point in the temperature distribution and the temperature at the measurement point in the temperature data, the model correcting part 706 corrects the analysis model so as to cancel the difference.

The replacement candidate extracting part 707 extracts the replacement candidate for the freezing apparatus based on the temperature distribution estimated by the temperature distribution estimating part 704, which is obtained by the airflow analysis using the analysis model after correction.

Further, the replacement candidate extracting part 707 also generates a placement candidate of the extracted replacement candidate.

Further, the replacement candidate extracting part 707 can calculate a difference, that is the energy saving effect, between power consumption by the current freezing apparatus and power consumption when the replacement candidate is placed at the placement candidate in the freezing warehouse 3. Further, the replacement candidate extracting part 707 does not have to generate the placement candidate. In this case, the replacement candidate extracting part 707 calculates a difference between the power consumption by the current freezing apparatus and power consumption when the replacement candidate is placed at the same position as the current freezing apparatus.

Further, the replacement candidate extracting part 707 may make a proposal for changing placement of the current freezing apparatus without extracting the replacement candidate.

The output part 708 presents (outputs) the output data illustrated in Fig. 2 to the administrator of the replacement proposing apparatus 7.

### *** Description of Operation ***

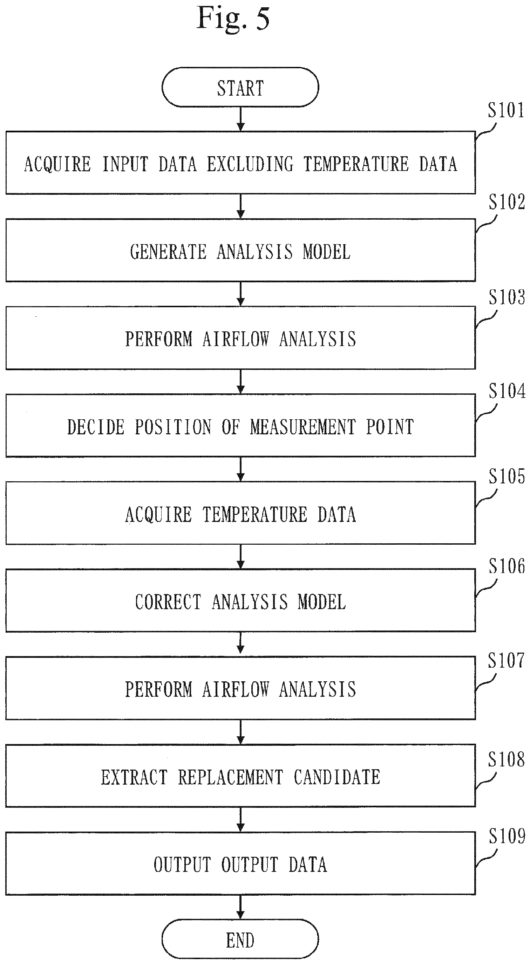

Next, an operation example of the replacement proposing apparatus 7 according to the present embodiment will be described with reference to Fig. 5.

First, in step S 101, the communication part 701 acquires the input data in Fig. 2 excluding the temperature data. As described above, the part of the input data may be acquired by the input part 702 from the administrator of the replacement proposing apparatus 7.

Next, in step S102, the model generating part 703 generates the analysis model.

Specifically, the model generating part 703 generates the analysis model by using the input data in Fig. 2 excluding the temperature data. As described above, the model generating part 703 can generate the analysis model according to an arbitrary method.

The model generating part 703 outputs the generated analysis model to the temperature distribution estimating part 704 and the model correcting part 706.

Next, in step S 103, the temperature distribution estimating part 704 performs the airflow analysis by using the analysis model generated in step S101. As described above, the temperature distribution estimating part 704 can perform the airflow analysis according to an arbitrary method.

The temperature distribution estimating part 704 outputs data of the temperature distribution in the freezing warehouse 3 obtained by the airflow analysis to the position deciding part 705 and the model correcting part 706.

Next, in step S104, the position deciding part 705 decides the position of the measurement point.

The position deciding part 705 decides as the position of the measurement point, for example, a position corresponding to the characteristic point in the temperature distribution in the freezing warehouse 3. As described above, the characteristic point is, for example, the point where the highest temperature is estimated in the temperature distribution, the point where the lowest temperature is estimated in the temperature distribution, or the like.

The position deciding part 705 outputs to the output part 708, position data indicating the position of the measurement point.

The output part 708 presents (outputs) to the administrator of the replacement proposing apparatus 7, the position data which is from the position deciding part 705. Then, the administrator of the replacement proposing apparatus 7 requests, for example, a user of the freezing warehouse 3 to place the temperature measuring apparatus 4 at the measurement point. The user of the freezing warehouse 3 places the temperature measuring apparatus 4 at the measurement point according to the position data.

Further, the position deciding part 705 may output the position data to the communication part 701, and the communication part 701 may transmit the position data to a terminal apparatus used by the user of the freezing warehouse 3. Also, in this case, the user of the freezing warehouse 3 places the temperature measuring apparatus 4 at the measurement point according to the position data. A notification of the position data to the user of the freezing warehouse 3 may be performed according to a method other than these.

Next, in step S105, the communication part 701 acquires from the collecting apparatus 5, the temperature data indicating the temperature measured by the temperature measuring apparatus 4 at the measurement point.

The communication part 701 outputs acquired temperature data to the model correcting part 706.

Note that, in addition to step S101, the communication part 701 may acquire the operation data of the freezing apparatus at this stage (step S 105). When the communication part 701 acquires the operation data, the communication part 701 outputs the acquired operation data to the model correcting part 706.

Next, in step S106, the model correcting part 706 corrects the analysis model.

Specifically, when there is the difference between the temperature at the measurement point in the temperature distribution generated by the temperature distribution estimating part 704 and the temperature at the measurement point in the temperature data, the model correcting part 706 corrects the analysis model so as to cancel the difference.

Further, when the operation data of the freezing apparatus is acquired in step S 105, the model correcting part 706 may correct the analysis model by using the operation data.

The model correcting part 706 corrects the analysis model while changing various types of parameters of the analysis model, for example, by a trial-and-error method so as to cancel the difference described above.

The model correcting part 706 outputs to the temperature distribution estimating part 704, the analysis model after correction.

Next, in step S 107, the temperature distribution estimating part 704 performs the airflow analysis by using the analysis model after correction.

The airflow analysis performed in step S107 differs only in that the analysis model after correction is used, and a procedure itself of the airflow analysis is the same as the airflow analysis in step S103.

In the airflow analysis in step S 107, the temperature distribution in the freezing warehouse 3 can be obtained, which is closer to a current state than the airflow analysis in step S103 is.

The temperature distribution estimating part 704 outputs to the replacement candidate extracting part 707, the data of the temperature distribution in the freezing warehouse 3 obtained from the airflow analysis.

Next, in step S108, the replacement candidate extracting part 707 extracts the replacement candidate based on the data of the temperature distribution obtained in step S107. The auxiliary storage device 903 illustrated in Fig. 3 stores data of a population of replacement candidates. The data of the population of replacement candidates indicates identifiers, capacities, and the like of the freezing apparatuses which are the replacement candidates.

The replacement candidate extracting part 707 extracts, for example, a problem in a current temperature distribution, and extracts as the replacement candidate, a freezing apparatus necessary for solving the extracted problem. The replacement candidate extracting part 707 extracts as the problem, for example, a spot whose temperature is high because the air flow does not reach, a spot which is too cold, an imbalance in the temperature distribution in the freezing warehouse 3, or the like.

Further, the replacement candidate extracting part 707 also generates the placement candidate of the extracted replacement candidate. More specifically, the replacement candidate extracting part 707 generates one of a first placement candidate where the replacement candidate is placed according to a current placement of the freezing apparatus, and a second placement candidate where the replacement candidate is placed differently from the current placement of the freezing apparatus. For example, the replacement candidate extracting part 707 requests the temperature distribution estimating part 704 for the air flow analysis in a case where the replacement candidate is placed according to the current placement of the freezing apparatus. Then, the replacement candidate extracting part 707 compares the temperature distribution obtained by a newly performed airflow analysis with the temperature distribution obtained by the airflow analysis in step S 107. When there is a significant difference between the two temperature distributions, the replacement candidate extracting part 707 selects the first placement candidate. On the other hand, when there is no significant difference between the two temperature distributions, the replacement candidate extracting part 707 selects the second placement candidate. Note that, a specific definition of the "significant difference" is decided by the administrator of the replacement proposing apparatus 7. When the second placement candidate is selected, the replacement candidate extracting part 707 tries various types of positions for the replacement candidate by the trial-and-error method, and adopts a placement candidate at which a significant difference is obtained in the temperature distribution.

Further, the replacement candidate extracting part 707 calculates a difference (energy saving effect) between the power consumption by the current freezing apparatus and the power consumption when the replacement candidate is placed in the freezing warehouse 3.

Finally, in step S 109, the output part 708 outputs the output data illustrated in Fig. 2.

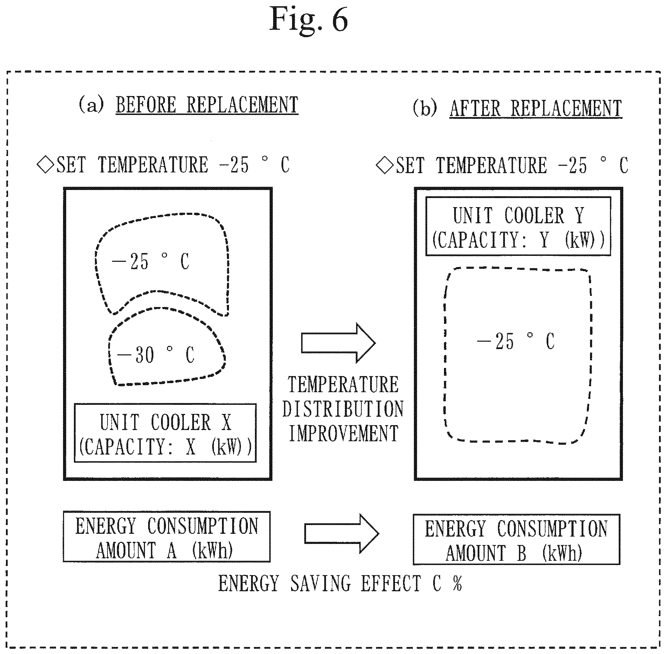

Fig. 6 illustrates an example of the output data.

(a) of Fig. 6 illustrates a state before replacement (a current state of the freezing warehouse 3), and (b) of Fig. 6 illustrates a state after replacement (a state of the freezing warehouse 3 when the replacement candidate is placed).

In (a) of Fig. 6, a unit cooler X is placed in a lower portion of the freezing warehouse 3. However, in (b) of Fig. 6, a unit cooler Y being the replacement candidate is placed in an upper portion which is the placement candidate, of the freezing warehouse 3. Further, (b) of Fig. 6 illustrates that a capacity of the unit cooler Y is Y (kW).

Further, (a) of Fig. 6 illustrates a temperature distribution before replacement, and (b) of Fig. 6 illustrates a temperature distribution after replacement, (a) of Fig. 6 illustrates that the temperature distribution is imbalanced (an area of -25 °C and an area of -30 °C). However, (b) of Fig. 6 illustrates that the temperature distribution is balanced.

Further, (a) of Fig. 6 illustrates that power consumption before replacement is A (kWh), and (b) of Fig. 6 illustrates that power consumption after replacement is B (kWh). Further, Fig. 6 illustrates that C % is expected as the energy saving effect.

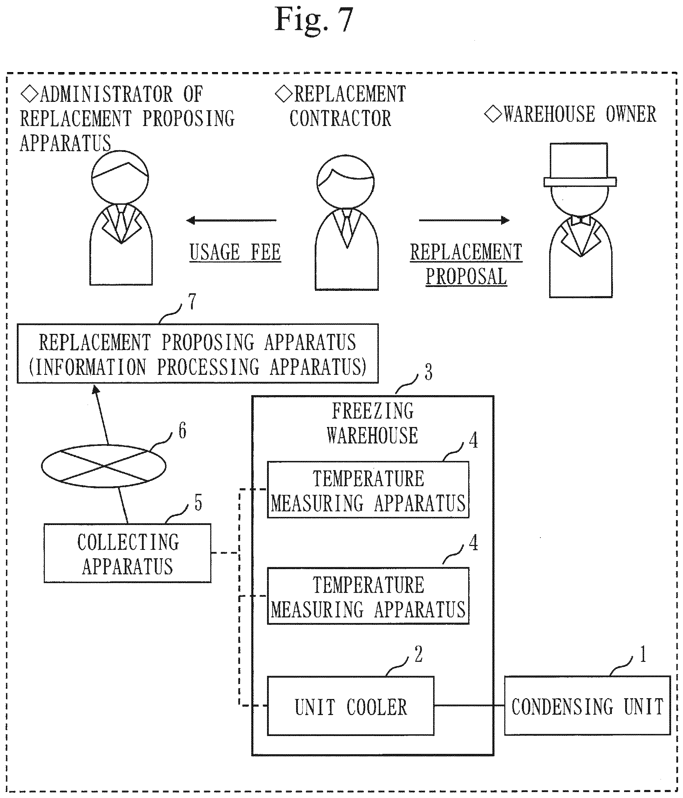

Fig. 7 illustrates an example of practice using the replacement proposing apparatus 7.

The administrator of the replacement proposing apparatus 7 performs management such as a version upgrading of the replacement proposing apparatus 7 and the like. A replacement contractor pays the administrator of the replacement proposing apparatus 7 a usage fee in order to use a replacement proposal (for example, the output data in Fig. 6) from the replacement proposing apparatus 7. The replacement contractor presents the replacement proposal from the replacement proposing apparatus 7 to a warehouse owner. The replacement contractor can make a highly accurate and effective replacement proposal without developing and managing the replacement proposing apparatus 7 on its own.

Further, although only a single freezing warehouse 3 is illustrated in Fig. 7, the replacement proposing apparatus 7 can make replacement proposals for a plurality of freezing warehouses 3. In this case, the replacement proposing apparatus 7 can utilize a replacement proposal made in the past for a replacement proposal for a new freezing warehouse 3. A case is assumed where, for example, the replacement candidate extracting part 707 has extracted a freezing apparatus A as a replacement candidate for a freezing warehouse A in the past, and newly extracts a replacement candidate for a freezing warehouse B. In this case, the replacement candidate extracting part 707 calculates a degree of similarity between the freezing warehouse A and the freezing warehouse B. Then, when the calculated degree of similarity is equal to or more than a threshold value, the replacement candidate extracting part 707 can extract as the replacement candidate for the freezing apparatus placed in the freezing warehouse B, the freezing apparatus A which is the replacement candidate extracted for the freezing warehouse A. In this way, the administrator of the replacement proposing apparatus 7 can improve efficiency in work by utilizing a past replacement proposal for a freezing warehouse 3 similar to the freezing warehouse 3 for which the replacement proposal has been made in the past.

### *** Description of Effect of Embodiment ***

As described above, in the present embodiment, the temperature distribution obtained by the airflow analysis using the analysis model and the temperature actually measured at the measurement point are collated with each other, and the analysis model is corrected based on the collation result. Therefore, according to the present embodiment, it is possible to obtain an accurate temperature distribution by performing the airflow analysis using the corrected analysis model. Further, since the accurate temperature distribution can be obtained, it is possible to extract an appropriate replacement candidate.

As a result, according to the present embodiment, it is possible to avoid increase in energy consumption due to occurrence of an overcooled place, deterioration in quality of a stored product due to occurrence of an uncooled place, mismatch in a capacity of the freezing apparatus, and the like.

Further, in the present embodiment, since an improvement status of the temperature distribution can be presented in a form that one can easily recognize the improvement status, it is possible to improve a proposal ability.

Note that, although the freezing apparatus placed in the freezing warehouse 3 has been described above, the indoor space is not limited to the freezing warehouse 3, and also, the temperature adjusting device placed in the indoor space is not limited to the freezing apparatus.

### *** Description of Hardware Configuration ***

Finally, supplementary descriptions of a hardware configuration of the replacement proposing apparatus 7 will be given.

The processor 901 illustrated in Fig. 3 is an IC (Integrated Circuit) that performs processing.

The processor 901 is a CPU (Central Processing Unit), a DSP (Digital Signal Processor), or the like.

The main storage device 902 illustrated in Fig. 3 is a RAM (Random Access Memory).

Further, the auxiliary storage device 903 illustrated in Fig. 3 is a ROM (Read Only Memory), a flash memory, an HDD (Hard Disk Drive), or the like.

The communication device 904 illustrated in Fig. 3 is an electronic circuit that executes a communication process of data.

The communication device 904 is, for example, a communication chip or an NIC (Network Interface Card).

The input/output device 905 illustrated in Fig. 3 is, for example, a keyboard, a mouse, a display device, or the like.

In addition, an OS (Operating System) is also stored in the auxiliary storage device 903.

Then, at least a part of the OS is executed by the processor 901.

While executing at least the part of the OS, the processor 901 executes programs that realize functions of the communication part 701, the input part 702, the model generating part 703, the temperature distribution estimating part 704, the position deciding part 705, the model correcting part 706, the replacement candidate extracting part 707, and the output part 708.

By the processor 901 executing the OS, task management, memory management, file management, communication control, and the like are performed.

Further, at least one of information, data, a signal value, and a variable value indicating a processing result of the communication part 701, the input part 702, the model generating part 703, the temperature distribution estimating part 704, the position deciding part 705, the model correcting part 706, the replacement candidate extracting part 707, and the output part 708 is stored in at least one of the main storage device 902, the auxiliary storage device 903, and a register and a cache memory in the processor 901.

Further, the programs that realize the functions of the communication part 701, the input part 702, the model generating part 703, the temperature distribution estimating part 704, the position deciding part 705, the model correcting part 706, the replacement candidate extracting part 707, and the output part 708 may be stored in a portable recording medium such as a magnetic disk, a flexible disk, an optical disk, a compact disk, a Blu-ray (registered trademark) disk, or a DVD.

Further, "part" of the communication part 701, the input part 702, the model generating part 703, the temperature distribution estimating part 704, the position deciding part 705, the model correcting part 706, the replacement candidate extracting part 707, and the output part 708 may be read as "circuit" or "step" or "procedure" or "process".

Further, the replacement proposing apparatus 7 may be realized by a processing circuit. The processing circuit is, for example, a logic IC (Integrated Circuit), a GA (Gate Array), an ASIC (Application Specific Integrated Circuit), or an FPGA (Field-Programmable Gate Array).

Besides, in the present specification, a superordinate concept of the processor and the processing circuit is referred to as "processing circuitry".

That is, each of the processor and the processing circuit is a specific example of the "processing circuitry".

### Reference Signs List

1: condensing unit, 2: unit cooler, 3: freezing warehouse, 4: temperature measuring apparatus, 5: collecting apparatus, 6: Internet, 7: replacement proposing apparatus, 701: communication part, 702: input part, 703: model generating part, 704: temperature distribution estimating part, 705: position deciding part, 706: model correcting part, 707: replacement candidate extracting part, 708: output part, 901: processor, 902: main storage device, 903: auxiliary storage device, 904: communication device, 905: input/output device.

## Claims

1. An information processing apparatus (7) comprising:
a model generating part (703) configured to generate an analysis model for an airflow analysis of an indoor space where a temperature adjusting device which performs a temperature adjustment is placed;
a temperature distribution estimating part (704) configured to perform the airflow analysis of the indoor space by using the analysis model and estimate a temperature distribution in the indoor space;
a temperature acquiring part (701) configured to acquire a temperature measured at a measurement point in the indoor space; and
a model correcting part (706) configured to collate the temperature distribution estimated by the temperature distribution estimating part with the temperature at the measurement point acquired by the temperature acquiring part, and correct the analysis model based on a collation result;
wherein the temperature distribution estimating part (704) performs the airflow analysis of the indoor space by using the analysis model after being corrected by the model correcting part, and estimates the temperature distribution in the indoor space,
**characterized in that**
the information processing apparatus further comprises:
a replacement candidate extracting part (707)
configured to extract as a replacement candidate device, a temperature adjusting device being a replacement candidate for the temperature adjusting device, based on a temperature distribution from the airflow analysis using the analysis model after being corrected, the temperature distribution being estimated by the temperature distribution estimating part,
configured to calculate a degree of similarity between another indoor space than the indoor space and the indoor space, and
configured to extract, when the calculated degree of similarity is equal to or more than a threshold, the replacement candidate device extracted for the indoor space, as a temperature adjusting device being a replacement candidate for a temperature adjusting device placed in the another indoor space.

2. The information processing apparatus according to claim 1, the information processing apparatus further comprising
a position deciding part (705) configured to analyze the temperature distribution estimated by the temperature distribution estimating part, and configured to decide a position of the measurement point.

3. The information processing apparatus according to claim 2, wherein the position deciding part is configured to decide as the position of the measurement point, a characteristic point in the temperature distribution estimated by the temperature distribution estimating part.

4. The information processing apparatus according to claim 1, wherein the replacement candidate extracting part is configured to generate a placement candidate for the replacement candidate device extracted.

5. The information processing apparatus according to claim 4,
wherein the replacement candidate extracting part is configured to generate one of a first placement candidate where the replacement candidate device is placed according to a current placement of the temperature adjusting device and a second placement candidate where the replacement candidate device is placed differently from the current placement of the temperature adjusting device.

6. The information processing apparatus according to claim 5, wherein the replacement candidate extracting part is configured to select one of the first placement candidate and the second placement candidate based on the temperature distribution estimated by the temperature distribution estimating part.

7. The information processing apparatus according to claim 1, wherein the replacement candidate extracting part is configured to calculate a difference between power consumption by the temperature adjusting device and power consumption when the replacement candidate device is placed in the indoor space.

8. The information processing apparatus according to claim 1, the information processing apparatus further comprising
an output part (708) configured to output a current temperature distribution in the indoor space when the temperature adjusting device is placed in the indoor space and a temperature distribution in the indoor space when the replacement candidate device is placed in the indoor space.

9. An information processing method comprising:
generating, by a computer, an analysis model for an airflow analysis of an indoor space where a temperature adjusting device which performs a temperature adjustment is placed;
performing, by the computer, the airflow analysis of the indoor space by using the analysis model and estimating a temperature distribution in the indoor space;
acquiring, by the computer, a temperature measured at a measurement point in the indoor space;
collating, by the computer, the temperature distribution estimated with the temperature at the measurement point acquired, and correcting the analysis model based on a collation result; and
performing, by the computer, the airflow analysis of the indoor space by using the analysis model after being corrected, and estimating the temperature distribution in the indoor space,
**characterized in that**
the information processing method further comprises:
extracting, by the computer, as a replacement candidate device, a temperature adjusting device being a replacement candidate for the temperature adjusting device, based on a temperature distribution estimated from the airflow analysis using the analysis model after being corrected;
calculating, by the computer, a degree of similarity between another indoor space than the indoor space and the indoor space; and
extracting, by the computer, when the calculated degree of similarity is equal to or more than a threshold, the replacement candidate device extracted for the indoor space, as a temperature adjusting device being a replacement candidate for a temperature adjusting device placed in the another indoor space.

## Patentansprüche

1. Informationsverarbeitungsvorrichtung (7), umfassend:
einen Modellgenerierungsteil (703), der konfiguriert ist, ein Analysemodell für eine Luftstromanalyse eines Innenraums zu generieren, wo eine Temperatureinstellungseinrichtung platziert ist, die eine Temperatureinstellung durchführt;
einen Temperaturverteilungsschätzteil (704), der konfiguriert ist, die Luftstromanalyse des Innenraums unter Verwendung des Analysemodells durchzuführen und eine Temperaturverteilung in dem Innenraum zu schätzen;
einen Temperaturerfassungsteil (701), der konfiguriert ist, eine an einem Messpunkt in dem Innenraum gemessene Temperatur zu erfassen; und
einen Modellkorrekturteil (706), der konfiguriert ist, die von dem Temperaturverteilungsschätzteil geschätzte Temperaturverteilung mit der von dem Temperaturerfassungsteil erfassten Temperatur an dem Messpunkt abzugleichen und das Analysemodell basierend auf einem Abgleichsergebnis zu korrigieren;
wobei der Temperaturverteilungsschätzteil (704) die Luftstromanalyse des Innenraums unter Verwendung des Analysemodells nach der Korrektur durch den Modellkorrekturteil durchführt und die Temperaturverteilung in dem Innenraum schätzt,
**dadurch gekennzeichnet, dass** die Informationsverarbeitungsvorrichtung ferner umfasst:
einen Ersatzkandidatenextraktionsteil (707), der
konfiguriert ist, als eine Ersatzkandidateneinrichtung eine Temperatureinstellungseinrichtung zu extrahieren, die ein Ersatzkandidat für die Temperatureinstellungseinrichtung ist, basierend auf einer Temperaturverteilung aus der Luftstromanalyse unter Verwendung des Analysemodells nach der Korrektur, wobei die Temperaturverteilung durch den Temperaturverteilungsschätzteil geschätzt wird,
konfiguriert ist, einen Grad der Ähnlichkeit zwischen einem anderen Innenraum als dem Innenraum und dem Innenraum zu berechnen, und
konfiguriert ist, wenn der berechnete Grad der Ähnlichkeit gleich oder größer als ein Schwellenwert ist, die für den Innenraum extrahierte Ersatzkandidateneinrichtung als eine Temperatureinstellungseinrichtung zu extrahieren, die ein Ersatzkandidat für eine Temperatureinstellungseinrichtung ist, die in dem anderen Innenraum platziert ist bzw. wird.

2. Informationsverarbeitungsvorrichtung nach Anspruch 1, wobei die Informationsverarbeitungsvorrichtung ferner einen Positionsentscheidungs- bzw. -bestimmungsteil (705) umfasst, der konfiguriert ist, die durch den Temperaturverteilungsschätzteil geschätzte Temperaturverteilung zu analysieren, und konfiguriert ist, eine Position des Messpunkts zu entscheiden bzw. zu bestimmen.

3. Informationsverarbeitungsvorrichtung nach Anspruch 2, wobei der Positionsentscheidungsteil konfiguriert ist, als die Position des Messpunkts einen charakteristischen Punkt in der durch den Temperaturverteilungsschätzteil geschätzten Temperaturverteilung zu entscheiden bzw. zu bestimmen.

4. Informationsverarbeitungsvorrichtung nach Anspruch 1, wobei der Ersatzkandidatenextraktionsteil konfiguriert ist, einen Platzierungskandidaten für die extrahierte Ersatzkandidateneinrichtung zu generieren.

5. Informationsverarbeitungsvorrichtung nach Anspruch 4, wobei der Ersatzkandidatenextraktionsteil konfiguriert ist, einen eines ersten Platzierungskandidaten, wo die Ersatzkandidateneinrichtung gemäß einer aktuellen Platzierung der Temperatureinstellungseinrichtung platziert wird, und eines zweiten Platzierungskandidaten, wo die Ersatzkandidateneinrichtung anders als die aktuelle Platzierung der Temperatureinstellungseinrichtung platziert wird, zu generieren.

6. Informationsverarbeitungsvorrichtung nach Anspruch 5, wobei der Ersatzkandidatenextraktionsteil konfiguriert ist, einen des ersten Platzierungskandidaten und des zweiten Platzierungskandidaten basierend auf der durch den Temperaturverteilungsschätzteil geschätzten Temperaturverteilung auszuwählen.

7. Informationsverarbeitungsvorrichtung nach Anspruch 1, wobei der Ersatzkandidatenextraktionsteil konfiguriert ist, eine Differenz zwischen Leistungsverbrauch durch die Temperatureinstellungseinrichtung und Leistungsverbrauch, wenn die Ersatzkandidateneinrichtung in dem Innenraum platziert ist, zu berechnen.

8. Informationsverarbeitungsvorrichtung nach Anspruch 1, wobei die Informationsverarbeitungsvorrichtung ferner einen Ausgabeteil (708) umfasst, der konfiguriert ist, eine aktuelle Temperaturverteilung in dem Innenraum, wenn die Temperatureinstellungseinrichtung in dem Innenraum platziert ist, und eine Temperaturverteilung in dem Innenraum, wenn die Ersatzkandidateneinrichtung in dem Innenraum platziert ist, auszugeben

9. Informationsverarbeitungsverfahren, umfassend:
Generieren, durch einen Computer, eines Analysemodells für eine Luftstromanalyse eines Innenraums, wo eine Temperatureinstellungseinrichtung platziert ist, die eine Temperatureinstellung durchführt;
Durchführen, durch den Computer, der Luftstromanalyse des Innenraums unter Verwendung des Analysemodells und Schätzen einer Temperaturverteilung in dem Innenraum;
Erfassen, durch den Computer, einer an einem Messpunkt in dem Innenraum gemessenen Temperatur;
Abgleichen, durch den Computer, der geschätzten Temperaturverteilung mit der Temperatur an dem erfassten Messpunkt und Korrigieren des Analysemodells basierend auf einem Abgleichsergebnis; und
Durchführen, durch den Computer, der Luftstromanalyse des Innenraums unter Verwendung des Analysemodells nach der Korrektur und Schätzen der Temperaturverteilung in dem Innenraum,
**dadurch gekennzeichnet, dass** das Informationsverarbeitungsverfahren ferner umfasst:
Extrahieren, durch den Computer, als eine Ersatzkandidateneinrichtung, einer Temperatureinstellungseinrichtung, die ein Ersatzkandidat für die Temperatureinstellungseinrichtung ist, basierend auf einer aus der Luftstromanalyse geschätzten Temperaturverteilung unter Verwendung des Analysemodells nach der Korrektur,
Berechnen, durch den Computer, eines Grades der Ähnlichkeit zwischen einem anderen Innenraum als dem Innenraum und dem Innenraum; und
Extrahieren, durch den Computer, wenn der berechnete Grad der Ähnlichkeit gleich oder größer als ein Schwellenwert ist, die für den Innenraum extrahierte Ersatzkandidateneinrichtung als eine Temperatureinstellungseinrichtung, die ein Ersatzkandidat für eine Temperatureinstellungseinrichtung ist, die in dem anderen Innenraum platziert ist bzw. wird.

## Revendications

1. Appareil de traitement d'informations (7) comprenant :
une partie de génération de modèle (703) configurée pour générer un modèle d'analyse pour une analyse de flux d'air d'un espace intérieur où est placé un dispositif de réglage de température qui réalise un réglage de la température ;
une partie d'estimation de répartition de température (704) configurée pour réaliser l' analyse de flux d'air de l'espace intérieur en utilisant le modèle d'analyse et estimer une répartition de température dans l'espace intérieur ;
une partie d'acquisition de température (701) configurée pour acquérir une température mesurée à un point de mesure dans l'espace intérieur ; et
une partie de correction de modèle (706) configurée pour collationner la répartition de température estimée par la partie d'estimation de répartition de température avec la température au point de mesure acquise par la partie d'acquisition de température, et corriger le modèle d'analyse sur la base d'un résultat de collation ;
dans lequel la partie d'estimation de répartition de température (704) réalise l'analyse de flux d'air de l'espace intérieur en utilisant le modèle d'analyse après sa correction par la partie de correction de modèle, et estime la répartition de température dans l'espace intérieur.
**caractérisé en ce que**
l'appareil de traitement d'informations comprend en outre :
une partie d'extraction de candidat de remplacement (707)
configurée pour extraire en tant que dispositif candidat de remplacement, un dispositif de réglage de température qui est un candidat de remplacement pour le dispositif de réglage de température, sur la base d'une répartition de température provenant de l'analyse de flux d'air à l'aide du modèle d'analyse après sa correction, la répartition de température étant estimée par la partie d'estimation de répartition de température,
configurée pour calculer un degré de similarité entre un espace intérieur autre que l'espace intérieur et l'espace intérieur, et
configurée pour, lorsque le degré de similarité calculé est égal ou supérieur à un seuil, extraire le dispositif candidat de remplacement extrait pour l'espace intérieur en tant que dispositif de réglage de température qui est un candidat de remplacement pour un dispositif de réglage de température placé dans l'autre espace intérieur.

2. Appareil de traitement d'informations selon la revendication 1, l'appareil de traitement d'informations comprenant en outre
une partie de décision de position (705) configurée pour analyser la répartition de température estimée par la partie d'estimation de répartition de température, et configurée pour décider d'une position du point de mesure.

3. Appareil de traitement d'informations selon la revendication 2, dans lequel la partie de décision de position est configurée pour décider, en tant que position du point de mesure, d'un point caractéristique dans la répartition de température estimée par la partie d'estimation de répartition de température.

4. Appareil de traitement d'informations selon la revendication 1, dans lequel la partie d'extraction de candidat de remplacement est configurée pour générer un candidat au placement pour le dispositif candidat de remplacement extrait.

5. Appareil de traitement d'informations selon la revendication 4,
dans lequel la partie d'extraction de candidat de remplacement est configurée pour générer l'un parmi un premier candidat au placement où le dispositif candidat de remplacement est placé selon un placement actuel du dispositif de réglage de température et un deuxième candidat au placement où le dispositif candidat de remplacement est placé différemment du placement actuel du dispositif de réglage de température.

6. Appareil de traitement d'informations selon la revendication 5, dans lequel la partie d'extraction de candidat de remplacement est configurée pour sélectionner un parmi le premier candidat au placement et le deuxième candidat au placement sur la base de la répartition de température estimée par la partie d'estimation de répartition de température.

7. Appareil de traitement d'informations selon la revendication 1, dans lequel la partie d'extraction de candidat de remplacement est configurée pour calculer une différence entre la consommation d'énergie par le dispositif de réglage de température et la consommation d'énergie lorsque le dispositif candidat de remplacement est placé dans l'espace intérieur.

8. Appareil de traitement d'informations selon la revendication 1, l'appareil de traitement d'informations comprenant en outre
une partie de sortie (708) configurée pour délivrer une répartition de température actuelle dans l'espace intérieur lorsque le dispositif de réglage de température est placé dans l'espace intérieur et une répartition de température dans l'espace intérieur lorsque le dispositif candidat de remplacement est placé dans l'espace intérieur.

9. Procédé de traitement d'informations comprenant le fait :
de générer, par un ordinateur, un modèle d'analyse pour un analyse de flux d'air d'un espace intérieur où est placé un dispositif de réglage de température qui réalise un réglage de la température,
de réaliser, par l'ordinateur, l'analyse de flux d'air de l'espace intérieur en utilisant le modèle d'analyse et d'estimer une répartition de température dans l'espace intérieur ;
d'acquérir, par l'ordinateur, une température mesurée à un point de mesure dans l'espace intérieur ;
de collationner, par l'ordinateur, la répartition de température estimée avec la température au point de mesure acquise, et de corriger le modèle d'analyse sur la base d'un résultat de collation ; et
de réaliser, par l'ordinateur, l'analyse de flux d'air de l'espace intérieur en utilisant le modèle d'analyse après sa correction, et d'estimer la répartition de température dans l'espace intérieur,
**caractérisé en ce que**
le procédé de traitement d'informations comprend en outre le fait :
d'extraire, par l'ordinateur, en tant que dispositif candidat de remplacement, un dispositif de réglage de température qui est un candidat de remplacement pour le dispositif de réglage de température, sur la base d'une répartition de température estimée provenant de l'analyse de flux d'air à l'aide du modèle d'analyse après sa correction ;
de calculer, par l'ordinateur, un degré de similarité entre un espace intérieur autre que l'espace intérieur et l'espace intérieur ; et
lorsque le degré de similarité calculé est égal ou supérieur à un seuil, d'extraire, par l'ordinateur, le dispositif candidat de remplacement extrait pour l'espace intérieur, en tant que dispositif de réglage de température qui est un candidat de remplacement pour un dispositif de réglage de température placé dans l'autre espace intérieur.
